(19) Europäisches Patentamt
European Patent Office
Office européen des brevets

(11) Numéro de publication : **0 508 878 A1**

(12) **DEMANDE DE BREVET EUROPEEN**


(21) Numéro de dépôt : **92400960.8**

(22) Date de dépôt : **07.04.92**

(51) Int. Cl.[5] : **H01S 3/19**, H01L 31/167, H01L 21/22

(30) Priorité : **12.04.91 FR 9104513**

(43) Date de publication de la demande : **14.10.92 Bulletin 92/42**

(84) Etats contractants désignés : **DE GB**



(71) Demandeur : **THOMSON-CSF**
**51, Esplanade du Général de Gaulle**
**F-92800 Puteaux (FR)**

(72) Inventeur : **de Cremoux, Baudoin**
**THOMSON-CSF, SCPI, Cédex 67**
**F-92045 Paris la Défense (FR)**
Inventeur : **Razeghi, Manijeh**
**THOMSON-CSF, SCPI, Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**


# (54) Procédé de réalisation de dispositifs optoélectroniques à semiconducteurs.


(57) L'invention concerne la réalisation d'un dispositif optoélectronique comportant au moins un puits quantique dont les barrières sont en GaInP et le puits en GaAs. On pratique par interdiffusion d'éléments entre barrières et puits quantiques de façon à ce qu'il y ait transport au moins d'éléments Indium d'une barrière vers le puits quantique.

Applications : Réalisation de laser à puits quantiques, de photodétecteurs et de guides optiques.

DIFFUSION Zn
7
6
5
4
3
2
1
SUBSTRAT


FIG. 4

EP 0 508 878 A1

Jouve, 18, rue Saint-Denis, 75001 PARIS

L'invention concerne un procédé de réalisation de dispositifs optoélectroniques à semiconducteurs et notamment de lasers à puits quantiques.

L'invention est plus particulièrement applicable à la réalisation de lasers à base de GaAs/GaInP à cavité verticale ou horizontale c'est-à-dire à émission par la surface ou à émission par la tranche.

Une application préférentielle de l'invention est la réalisation de dispositifs optoélectroniques tels que lasers intégrés avec des guides optiques. Dans une telle application, l'interconnexion des dispositifs optoélectroniques est facilitée.

L'association de plusieurs dispositifs optoélectroniques nécessite l'association de dispositifs constitués de matériaux d'énergies de bandes interdites différentes. Pour une longueur d'onde d'émission déterminée, le matériau de la couche active d'un laser doit présenter une énergie de bande interdite Eg déterminée. Pour cette même longueur d'onde un élément de guidage doit présenter une énergie de bande interdite supérieure à l'énergie de bande interdite Eg du matériau laser pour être transparent à cette longueur d'onde. Inversement un détecteur pour être absorbant à cette même longueur d'onde doit avoir une énergie de bande interdite au plus égale à l'énergie de bande interdite Eg du matériau laser. cela peut être illustré par la relation :

$$Eg_{détecteur} \leqq Eg_{laser} < Eg_{guide}$$

L'invention concerne l'association de plusieurs dispositifs optoélectroniques et présente l'avantage de réduire les étapes de réalisation (d'épitaxie) de ce type de dispositif.

L'invention concerne donc un procédé de réalisation de dispositifs optoélectroniques à semiconducteurs, caractérisé en ce qu'il comporte la réalisation d'au moins un puits quantique à semiconducteur suivi d'une interdiffusion des barrières du puits quantique de façon à ce qu'il y ait transport d'éléments semiconducteurs de cette barrière vers le puits quantique.

Les différents objets et caractéristiques de l'invention apparaîtront plus clairement dans la description qui va suivre et dans les figures qui représentent :

– les figures 1 à 8, un exemple de procédé de réalisation selon l'invention par diffusion ;

– les figures 9 et 12, un exemple de procédé conforme au procédé des figures 1 à 8 pour réaliser un dispositif comportant des miroirs de Bragg ;

– les figures 13 à 16, un autre exemple de procédé selon l'invention par diffusion ;

– les figures 17 à 18, un exemple de procédé par implantation selon l'invention ;

– la figure 19, une combinaison de différents procédés selon l'invention.

Comme on l'a vu précédemment, le comportement optique d'un dispositif optoélectronique est lié à l'énergie de bande interdite du ou des matériaux qui le constituent.

Le concept de l'invention réside dans le fait de réaliser au moins une couche active enserrée entre deux couches de confinement et de provoquer le transfert d'éléments d'une couche de confinement vers la couche active ou inversement. On modifie ainsi les énergies de bandes interdites de ces différentes couches et donc leur comportement optique.

Ce transfert ou interdiffusion d'éléments entre couches peut être assisté par diffusion d'impuretés ou par implantation ionique.

Par exemple en partant d'un système de couches comprenant au moires une couche active de GaAs encadrée par deux couches de confinement de GaInP et en réalisant une diffusion de zinc, on va provoquer une interdiffusion de l'Indium des couches de confinement vers la couche active.

La couche active de GaAs va adopter une composition en GaInAs. Son énergie de bande interdite va diminuer et sa longueur d'onde correspondant à cette énergie de bande interdite va augmenter.

La couche de confinement soumise à la diffusion de zinc va également changer de composition. Par exemple, elle va passer d'une composition $Ga_{O,51}In_{O,49}P$ a une composition $Ga_{O,51+d}In_{0,49-d}P$. Son énergie de bande interdite va augmenter et la longueur d'onde correspondante va diminuer.

Si on réalise la diffusion du zinc dans une partie seulement du dispositif, on va donc réaliser, dans cette zone un laser capable d'émettre à une longueur d'onde déterminée. La couche active non soumise à cette diffusion garde une énergie de bande interdite supérieure à celle que prend la couche active soumise à interdiffusion. La zone non soumise à diffusion peut donc servir pour le guidage de l'onde émise par le laser.

De la même façon, on peut implanter, dans les mêmes couches, un photodétecteur.

En ce qui concerne le transfert d'éléments par implantation ionique on peut, dans le même exemple de système GaInP/GaAs/GaInP que précédemment, provoquer une interdiffusion d'éléments III et V tel que In et P. Cette interdiffusion pourra être réalisée par implantation d'ions germanium ou silicium.

La couche active passe de la composition GaAs à une composition $Ga_xIn_{1-x}As_yP_{1-y}$. Son énergie de bande interdite augmente et la longueur d'onde correspondante diminue.

La couche de confinement soumise à implantation passe de la composition GaInP à une composition $Ga_z\,In_{1-z}\,As_t\,P_{1-t}$. Son énergie de bande interdite diminue et la longueur d'onde correspondante augmente.

Une telle implantation ionique dans une couche active d'un laser aura donc pour effet de rendre cette couche transparente (réalisation d'un guide) à la longueur d'onde laser.

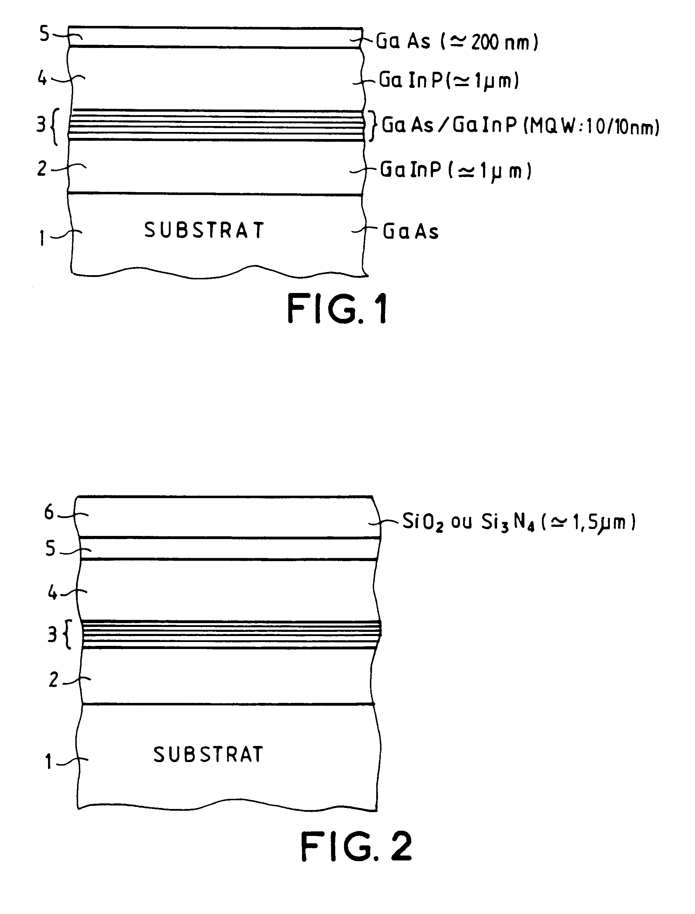

En se reportant à la figure 1, on va maintenant décrire un exemple de réalisation de base du procédé de l'invention.

On dispose d'un substrat 1 semiconducteur tel que du GaAs, de l'InP, du silicium, etc. A titre d'exemple ce substrat 1 est du GaAs de type n et on réalise sur ce substrat, par épitaxie, les différentes couches suivantes :

1) Une couche 2 de GaInP de type n de 1 μm d'épaisseur par exemple.

2) Une série 3 de superréseaux GaAs/GaInP non intentionnellement dopés (épaisseur du GaAs : environ 10 nm ; épaisseur du GaInP : environ 5 nm par exemple).

3) Une couche 4 de GaInP non intentionnellement dopée de 1μm d'épaisseur par exemple.

4) Une couche 5 de GaAs non intentionnellement dopée (de 200 nm d'épaisseur par exemple), servant de couche contact.

Ces épitaxies peuvent être faites par MOCVD, MOMBE, VPE ou LPE

Les couches épitaxiées subissent ensuite le traitement suivant :

1) Un dépôt 6 de silice (2 μm d'épaisseur par exemple) est réalisé sur la face supérieure (figure 2).

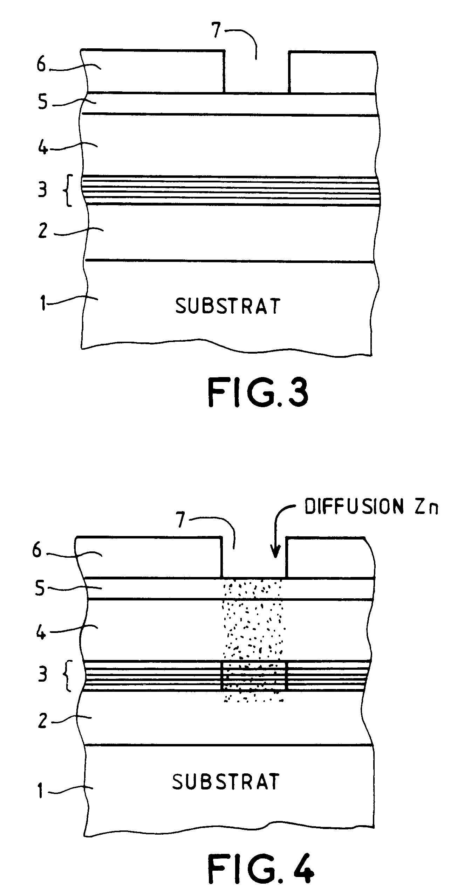

2) Par masquage optique ou électronique, on ouvre les fenêtres 7 (figure 3).

3) Une diffusion de zinc est opérée à travers le masque de silice par les fenêtres 7, de manière à définir des zones actives des composants à obtenir (figure 4). La diffusion du zinc va créer une interdiffusion des éléments III aux interfaces entre les barrières de GaInP et les puits quantiques de GaAs. De ce fait, les puits quantiques de GaAs changent de nature chimique, en devenant localement des puits de GaInAs avec une énergie de gap plus petite et donc une longueur d'onde plus grande.

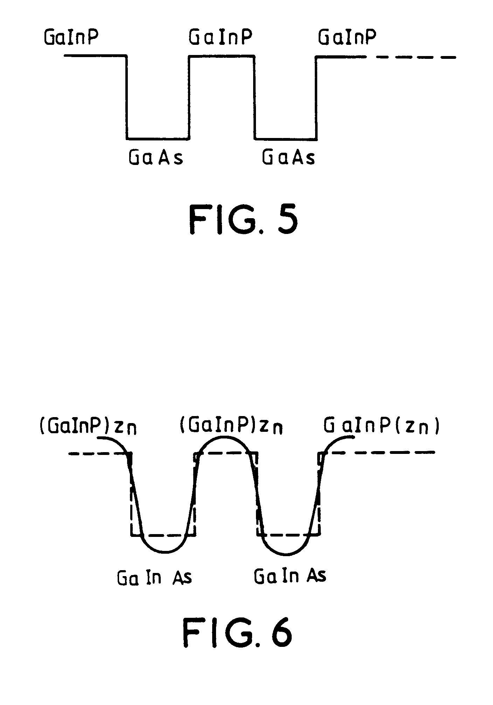

Avant la diffusion de zinc le profil de bande de conduction de chaque puits du superréseau 3 est tel que représentée en figure 5 :

GaInP/GaAs/GaInP

Après diffusion de zinc, l'indium étant diffusé des couches barrières vers la couche de puits quantique, le profil de bande de conduction est tel que représenté en figure 6 :

GaInP,Zn/GaInAs/GaInP,Zn

D'une part, en contrôlant le temps et la température de diffusion du zinc, on peut contrôler la composition du GaInAs et ainsi contrôler la longueur d'onde d'émission de la structure quantique.

D'autre part, le superréseau de puits quantique est entouré par des barrières 2 et 4 de GaInP et, 1 et 5 de GaAs de types p et n, lesquelles servent de couches de confinement de types p et n.

Nous créons ainsi une jonction p-n.

Par la technologie suivante, on fabrique des lasers émettant par la surface :

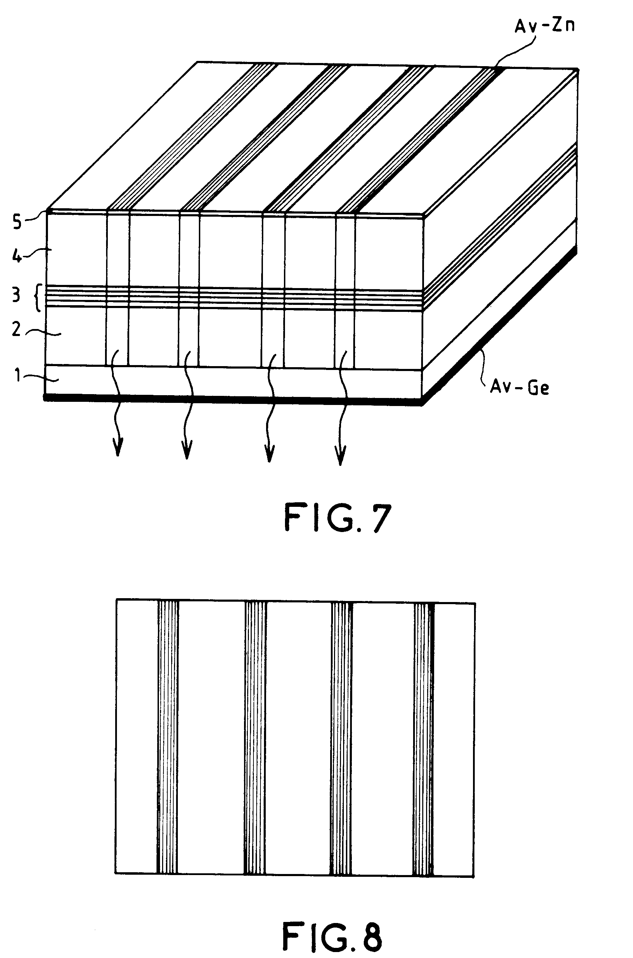

1) Les contacts ohmiques de type p sont réalisés par dépôt d'AuZn, les contacts ohmiques de type n étant réalisés par dépôt d'AuGe sur les faces avant et arrière de l'échantillon selon le motif représenté sur les figures 7 et 8.

2) On peut également amincir localement le substrat au niveau des zones dopées de la couche active 3 de manière à réaliser les fenêtres optiques au travers desquelles a lieu l'émission laser mais cela n'est pas forcément indispensable si le substrat est transparent.

La structure précédemment décrite peut être améliorée si on y incorpore des réflecteurs de Bragg. Ceux-ci à base de superréseaux GaAs-GaInP, permettent de réaliser une cavité optique de haute réflectivé pour l'effet laser ; on profite dans cet effet de la grande différence existant entre les indices optiques respectifs du GaAs et du GaInP.

Le procédé de réalisation de cette structure est le suivant :

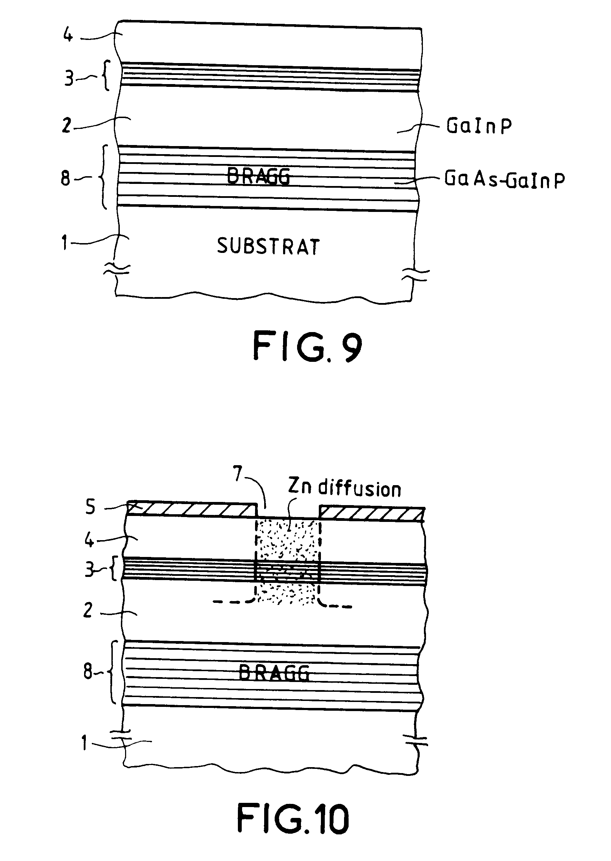

Les couches suivantes sont d'abord réalisées en mettant en oeuvre les techniques de MOCVD, MOMBE, VPE ou LPE sur un substrat 1 qui peut être GaAs, InP, Si, ... (figure 9).

1) Un premier superréseau 8 (GaAs-GaInP) de type n destiné à former un premier réflecteur de Bragg, l'épaisseur des couches de GaAs et de GaInP ainsi que la superpériode étant choisis en fonction de la longueur d'onde d'émission du laser ; 10 à 20 périodes de superréseau GaAs-GaInP sont suffisantes pour fabriquer le réflecteur de Bragg.

2) Une couche 2 de GaInP de type n de 1 μm d'épaisseur.

3) Une série 3 de superréseaux GaAs-GaInP (épaisseur du GaAs : environ 10 nm, épaisseur du GaInP : environ 5 nm).

4) Une couche 4 de GaInP non intentionnellement dopée de 1 μm d'épaisseur par exemple.

Les couches épitaxiales subissent ensuite le traitement suivant (figure 10) :

1) Un dépôt 5 de silice de 2 μm d'épaisseur est réalisé sur la face supérieure.

2) Par masquage optique ou électronique, on ouvre des fenêtres 7.

3) Une diffusion de zinc est opérée à travers le masque de silice par les fenêtres 7, de manière à définir les zones actives des composants à obtenir. La diffusion de zinc va créer une interdiffusion des éléments III aux interfaces entre les barrières de GaInP et les puits quantiques de GaAs. De ce fait, les puits quantiques de GaAs changent de nature chimique, en devenant localement des puits de GaInAs avec une énergie de gap plus petite et une longueur d'onde plus grande.

Comme précédemment, en contrôlant le temps et la température de diffusion du zinc, on peut contrôler la composition du GaInAs et ainsi contrôler la longueur d'onde d'émission de la structure quantique.

De même, ce puits quantique est entouré par des barrières de GaInP et GaAs de types p et n, lesquelles servent de couches de confinement de types p et n.

Nous créons ainsi une jonction p-n.

Après enlèvement du masque de silice 5, on réaliser en mettant en oeuvre les techniques de MOCVD, MOMBE, VPE ou LPE un second superréseau 9 GaAs-GaInP de type p destiné à former le second réflecteur de Bragg, l'épaisseur des couches de GaAs et de GaInP ainsi que la période étant là encore choisis en fonction de la longueur d'onde d'émission du laser ; 10 à 20 périodes de superréseau GaAs-GaInP sont suffisantes pour fabriquer le réflecteur de Bragg.

On termine la fabrication de lasers de la manière suivante :

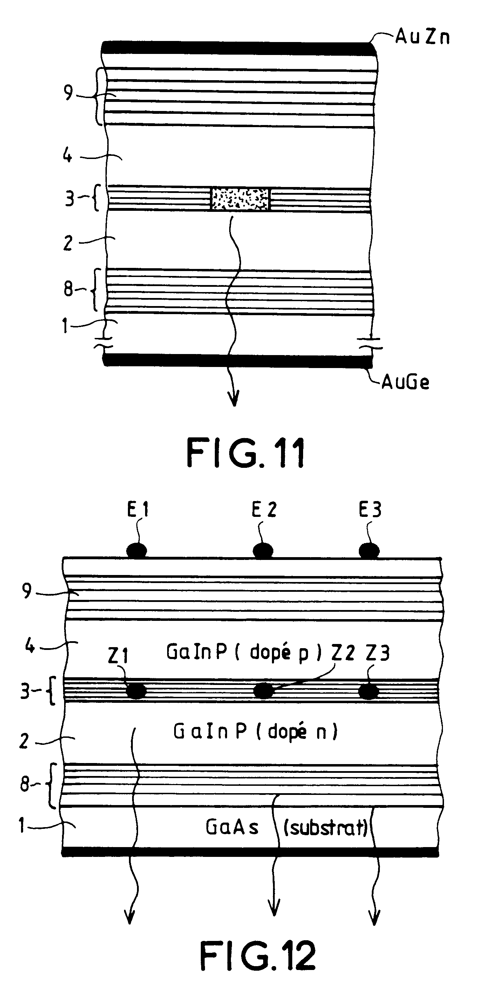

1) Les contacts ohmiques de type p sont réalisés par dépôt d'AuZn sur la face supérieure du dispositif, les contacts ohmiques de type n étant réalisés par dépôt d'AuGe sur la face inférieure (figure 11).

2) On peut également amincir localement le substrat au niveau des zones dopées de type p, de manière à réaliser les fenêtres optiques au travers desquelles a lieu l'émission laser mais cela n'est pas obligatoire si le substrat est transparent.

La figure 12 représente un dispositif laser dans lequel à chaque zone active Z1, Z2, Z3 ayant fait l'objet d'une interdiffusion d'éléments, est associée une électrode individuelle de commande E1, E2, E3.

Il convient cependant de prévoir une isolation des électrodes E1, E2, E3. Pour cela, on peut :

– soit doper localement de type p uniquement les zones Y1, Y2, Y3 du superréseau 9 ;

– soit graver les couches du superréseau 9 entre les zones Y1, Y2, Y3 ;

– soit réaliser une implantation de protons entre les zones Y1, Y2, Y3.

Les procédés décrits précédemment permettent de réaliser des lasers à émission par la surface.

Selon l'invention, on peut également réaliser des lasers à émission par la tranche et de préférence réaliser un laser intégré avec son guide optique d'interconnexion de sortie.

On va donc maintenant décrire la réalisation d'un tel laser.

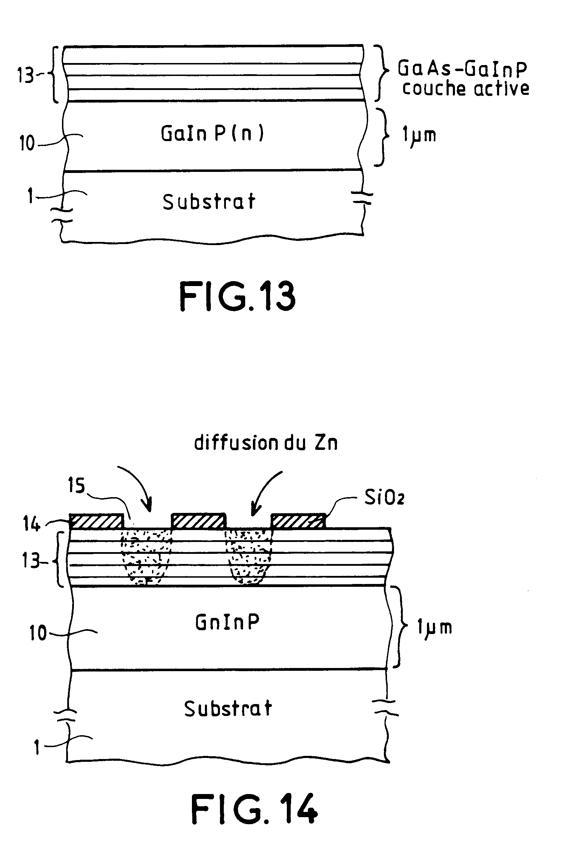

Sur un substrat 1, en GaAs par exemple, on réalise par épitaxie les couches suivantes (figure 13) :

– Une couche 10 de confinement de GaInP dopé de type n ayant une épaisseur d'environ 1 µm et un dopage $N_D - N_A = 10^{18} cm^{3}$.

– une série 13 de puits quantiques GaAs-GaInP pour la réalisation des couches actives du laser, et du guide (figure 13). Les couches des différents puits quantiques ayant pour épaisseur par exemple :

$$Lz = 10 \text{ nm}, L_N = 10 \text{ nm}.$$

On prévoira par exemple une dizaine de puits quantique. Ensuite, selon la figure 14, on réalise un masquage 14 par de la silice ($SiO_2$). Dans ce masquage, on réalise au moins une fenêtre 15.

Ensuite, comme précédemment, on procède à une diffusion de zinc à 510°C pendant 30 minutes (le temps de diffusion dépend de l'épaisseur de la couche active).

L'interdiffusion des éléments III à l'interface des puits quantiques GaAs-GaInP comme précédemment change l'énergie de gap de la couche active 13 de laser. En effet, la diffusion du zinc va créer une interdiffusion des éléments III aux interfaces entres les barrières de GaInP et les puits quantiques de GaAs. De ce fait, les puits quantiques de GaAs changent de nature chimique en devenant localement des puits de GaInAs avec une largeur de bande interdite plus petite et une longueur d'onde plus grande. Comme précédemment, en contrôlant le temps et la température de diffusion du zinc, on peut contrôler la composition du GaInAs et ainsi contrôler la longueur d'onde d'émission de la structure quantique. Le puits quantique ainsi obtenu est entouré par des matériaux ayant des largeurs de bandes interdites plus grandes et qui peuvent servir de guide pour la lumière émise par le laser.

Ensuite, on enlève la couche 14 de silice $SiO_2$.

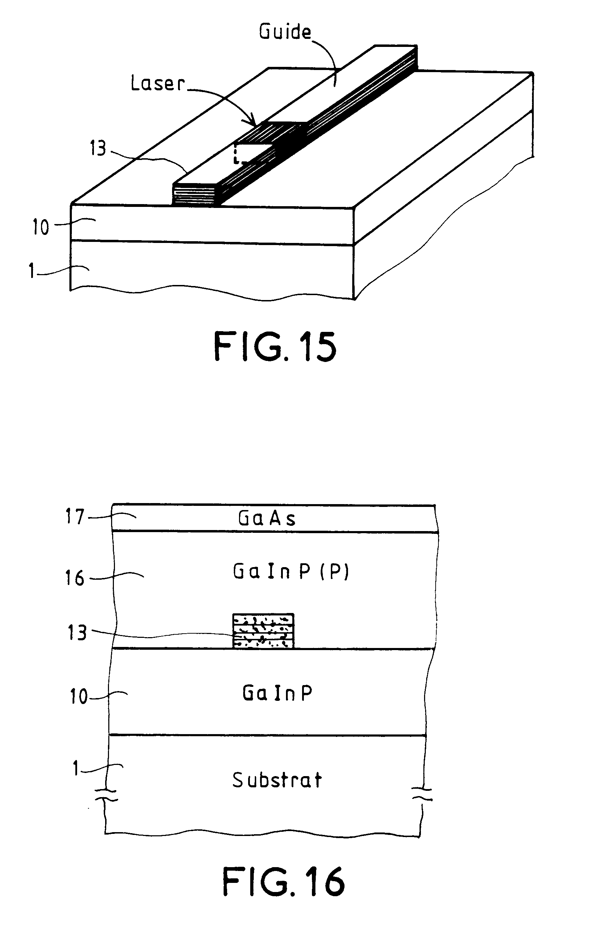

Pour déterminer les guides latéralement, on procède à une gravure de la couche active (superréseau 3) comme celà représenté en figure 15.

Ensuite, on réalise une couche 16 de GaInP, d'épaisseur environ 1 µm et dopée (P), à $5 \times 10^{17} cm^{-3}$, pour le confinement des couches lasers et des couches de guidage. Une autre couche 17 de GaAs est déposée. Elle est par exemple de 0,5 µm d'épaisseur et est dopée Zn avec $N_A - N_D \simeq 10^{19} cm^{-3}$ pour réaliser la couche contact ohmique. On obtient ainsi la structure de la figure 16.

Dans ce qui précède on décrit un procédé permettant par diffusion d'un matériau (du zinc dans l'exemple décrit) de provoquer une interdiffusion d'un élément constitutif d'une couche barrière d'un puits quantique vers la couche de puits quantique. Cependant, tout autre procédé permettant de réaliser une telle interdiffusion peut être utilisé.

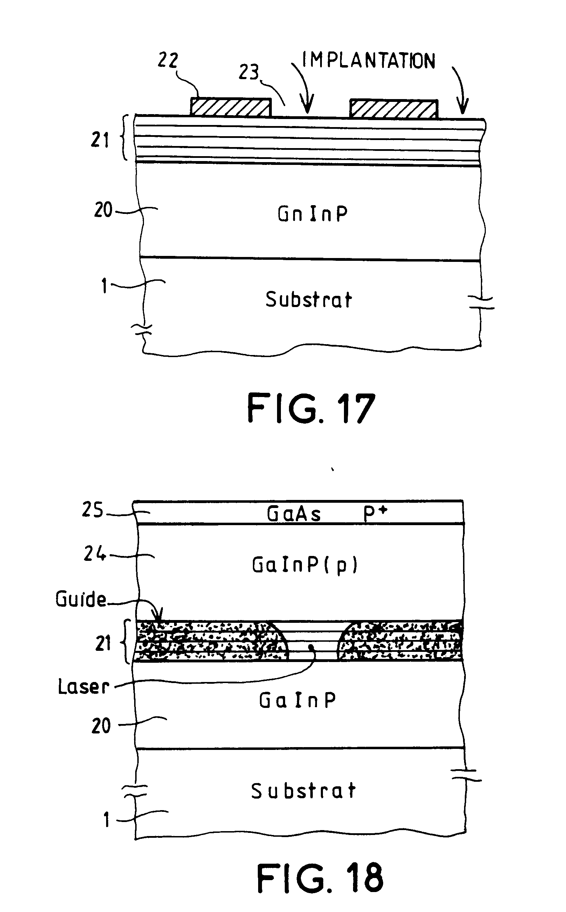

Par exemple, il est également possible d'utiliser un procédé par implantation ionique. On va donc décrire un tel procédé en se reportant à la figure 17.

On réalise sur un substrat 1, une couche 20 d'un matériau de guidage (GaInP par exemple). Sur cette couche, on réalise un superréseau de puits quantiques 21 constitué de couches barrières de GaInP et de couches de puits quantiques GaAs.

Une implantation de Germanium ou de Silicium va créer une interdiffusion des éléments III et V aux interfaces entre les couches barrières en GaInP et les couches de puits quantiques en GaAs. De ce fait, dans les zones d'interdiffusion, les couches de puits quantiques changent de nature chimique en devenant localement des puits de GaInAsP. Dans ces zones, la largeur de bande interdite d'un puits quantique augmente et la longueur d'onde guidée diminue. Les zones ayant fait l'objet d'une implantation peut donc servir de guide associé à un laser.

Pour réaliser un tel dispositif on dépose, comme cela est représenté sur la figure 17, un masque comportant des zones masquées 22 et des zones non masquées.

Les zones masquées 22 correspondent aux lasers à réaliser. Les zones non masquées permettent de faire les guides.

Après implantation, on enlève le masque 22 puis on définit les guides dans la ou les zones ayant subi l'implantation.

Ces guides sont par exemple gravés et leur position est telles qu'ils sont situés en continuité avec les lasers.

Ensuite, on recouvre l'ensemble par une couche de confinement 24 (en GaInP dopé p) et par une couche de contact (en GaAs dopé $p^+$).

On obtient une structure telle que représentée en figure 18.

Ce procédé a donc permis de réaliser un laser et son guide intégré.

Selon une variante du procédé de l'invention, il est possible en combinant une diffusion et une implantation de réaliser sur un même substrat un photodétecteur, un guide optique et un laser.

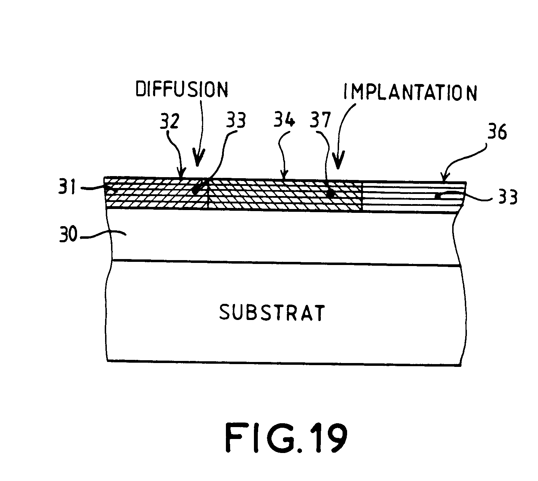

Comme précédemment, on réalise (figure 19) sur un substrat 1 une couche de confinement 30, un superréseau 31 de puits quantiques ( GAInP/GaAs par exemple ).

Dans le superréseau 31 on réalise une diffusion d'un matériau ( zinc par exemple ) permettant une interdiffusion d'éléments (Indium) aux interfaces des barrières et des puits du superréseau). Cette diffusion est faite dans au moins une zone 32 et permet de faire un photodétecteur 33.

Dans une autre zone 34, on réalise une implantation (silicium ou germanium par exemple) permettant également une interdiffusion d'éléments ( Indium, phosphore ) aux interfaces des barrières et des puits. Dans cette zone 34, on réalise ainsi un guide optique 37.

Une troisième zone 36 ne subit aucune interdiffusion et sert de laser 33. Il en est de même, par exemple de la zone 36 opposée à la zone 35 par rapport au laser 33.

Il est bien évident que la description qui précède n'a été faite qu'à titre d'exemple.

Les exemples de matériaux et les épaisseurs des couches n'ont été fournis que pour illustrer la description. Les procédés utilisés (diffusion et implantation) ne sont également fournis qu'à titre d'exemple.

## Revendications

1. Procédé de réalisation de dispositifs optoélectroniques à semiconducteurs, caractérisé en ce qu'il comporte la réalisation d'au moins un puits quantique à semiconducteur (3) dont les barrières sont en GaInP et le matériau du puits est du GaAs, suivi d'une interdiffusion d'éléments entre barrières et puits quantiques de façon à ce qu'il y ait transport au moins d'éléments Indium d'une barrière vers le puits quantique.

2. Procédé selon la revendication 1, caractérisé en ce que l'interdiffusion est réalisée par diffusion d'impuretés ou implantation d'éléments.

3. Procédé selon la revendication 2, caractérisé en ce que la diffusion ou l'implantation est précédée par la réalisation d'un masque (6) à travers lequel est réalisée la diffusion ou l'implantation.

4. Procédé selon la revendication 2, caractérisé en ce que la diffusion d'impuretés est réalisée à l'aide de zinc qui provoque le transport d'éléments Indium dans le matériau du puits.

5. Procédé selon la revendication 2, caractérisé en ce que l'implantation d'impuretés est réalisée à l'aide de silicium ou de germanium qui provoque le transport d'éléments In et P dans le matériau du puits.

6. Procédé selon la revendication 1, caractérisé en ce qu'il comporte la réalisation d'un empilement de puits quantiques (multi-puits quantiques).

7. Procédé selon la revendication 1, caractérisé en ce qu'il est précédé par la réalisation d'un premier empilement de couches (8) tenant lieu de réflecteur de Bragg et qu'il est terminé par la réalisation d'un deuxième empilement de couches (9) tenant lieu également de réflecteur de Bragg.

8. Procédé selon la revendication 1, caractérisé en ce qu'il permet la réalisation d'un laser par diffusion d'impuretés.

9. Procédé selon la revendication 1, caractérisé en ce qu'il permet la réalisation d'un photodétecteur par implantation.

10. Procédé selon la revendication 1, caractérisé en ce qu'il permet la réalisation sur un même substrat d'un laser par diffusion et d'un guide.

11. Procédé selon la revendication 1, caractérisé en ce qu'il permet la réalisation sur un même substrat d'un guide par implantation et d'un laser.

**12.** Procédé selon la revendication 1, caractérisé en ce qu'il permet la réalisation sur un même substrat d'un laser par diffusion, d'un photodétecteur par implantation et d'un guide dans des zones non soumises ni à diffusion ni à implantation.

5
4
3
2
1
SUBSTRAT
Ga As (≃ 200 nm)
Ga In P (≃ 1 μm)
Ga As / Ga In P (MQW : 10/10 nm)
Ga In P (≃ 1 μm)
Ga As


FIG. 1

6
5
4
3
2
1
SUBSTRAT
SiO2 ou Si3N4 (≃ 1,5 μm)


FIG. 2

7
6
5
4
3
2
1
SUBSTRAT

FIG.3

DIFFUSION Zn
7
6
5
4
3
2
1
SUBSTRAT

FIG.4

GaInP
GaInP
GaInP
GaAs
GaAs

FIG. 5

(GaInP)zn
(GaInP)zn
GaInP(zn)
Ga In As
Ga In As

FIG. 6

Av-Zn
5
4
3
2
1
Av-Ge

FIG. 7

FIG. 8

4
3
2
8
1
BRAGG
SUBSTRAT
GaInP
GaAs-GaInP

FIG. 9

7
Zn diffusion
5
4
3
2
8
1
BRAGG

FIG.10

AuZn
9
4
3
2
8
1
AuGe

FIG. 11

E1
E2
E3
9
4
GaInP ( dopé p )
Z1
Z2
Z3
3
2
GaInP ( dopé n )
8
1
GaAs
(substrat)

FIG.12

13
GaAs-GaInP
couche active
GaIn P(n)
1µm
10
1
Substrat

FIG.13

diffusion du Zn
15
SiO2
14
13
GnInP
1µm
10
Substrat
1

FIG. 14

Guide
Laser
13
10
1

FIG. 15

17 GaAs

16 GaInP (P)

13

10 GaInP

1 Substrat

FIG. 16

22
23
IMPLANTATION
21
20
GnInP
1
Substrat

FIG. 17

25
GaAs P+
24
GaInP(p)
Guide
21
Laser
GaInP
20
Substrat
1

FIG. 18

DIFFUSION
IMPLANTATION
32
33
34
37
36
31
33
30
SUBSTRAT

FIG.19

Office européen des brevets

# RAPPORT DE RECHERCHE EUROPEENNE

Numero de la demande

EP 92 40 0960

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | APPLIED PHYSICS LETTERS vol. 52, no. 17, 25 avril 1988, pages 1413-1415, New York, US; D.G. DEPPE et al.: "Impurity-induced layer disordering of high gap InAlGaP heterostructures" * le document en entier * | 1,2,4,8 | H 01 S 3/19<br>H 01 L 31/167<br>H 01 L 21/22 |
| Y | idem | 3,5-7,9-12 | |
| X | JOURNAL OF APPLIED PHYSICS vol. 64, no. 12, 15 décembre 1988, pages R93-R113, New York, US; D.G. DEPPE et al.: "Atom diffusion and impurity-induced layer disordering in quantum well III-V semiconductor heterostructures" * pages R93,R104-R110 * | 1,2,4,8 | |
| Y | idem | 3,5 | |
| Y | JOURNAL OF APPLIED PHYSICS vol. 66, no. 2, 15 juillet 1989, pages 482-487, New York, US; J.M. DALLESASSE et al.: "Impurity-induced layer disordering in InAlGaP-InGaP quantum-well heterostructures: Visible spectrum buried heterostructure lasers" * page 482 * | 6 | **DOMAINES TECHNIQUES RECHERCHES (Int. Cl.5)**<br>H 01 S<br>H 01 L |
| Y | IEEE PHOTONICS TECHNOLOGY LETTERS vol. 2, no. 1, janvier 1990, pages 1,2, New York, US; Y. KAWAMURA et al.: "InGaAs/InAlAs SCH-MQW lasers with superlattice optical confinement layers grown by MBE" * le document en entier * ---  -/- | 7 | |

Le présent rapport a été établi pour toutes les revendications

| Lieu de la recherche | Date d'achèvement de la recherche | Examinateur |
|---|---|---|
| BERLIN | 20-07-1992 | MUNNIX S J G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

Page 2

Office européen des brevets

# RAPPORT DE RECHERCHE EUROPEENNE

Numero de la demande

EP 92 40 0960

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | ELECTRONICS LETTERS vol. 24, no. 3, 4 février 1988, pages 181,182, Enage, GB; B.C. JOHNSON et al.: "Two-wavelength disordered quantum-well photodetector" * le document en entier * | 9 | |
| A | idem<br>--- | 12 | |
| Y | APPLIED PHYSICS LETTERS vol. 51, no. 24, 14 décembre 1987, pages 1983-1985, New York, US; R.L. THORNTON et al.: "Monolithic integration of a transparent dielectric waveguide into an active laser cavity by impurity-induced disordering" * le document en entier *<br>--- | 10,11 | |
| Y | APPLIED PHYSICS LETTERS vol. 50, no. 14, 6 avril 1987, pages 866-868, New York, US; F. JULIEN et al.: "Impurity-induced disorder-delineated optical waveguides in GaAs-AlGaAs superlattices" * le document en entier * | 12 | DOMAINES TECHNIQUES RECHERCHES (Int. Cl.5) |
| A | idem<br>--- | 10,11 | |
| A | IEEE LASERS AND ELECTRO-OPTICS SOCIETY ANNUAL MEETING, SANTA CLARA, CA, US 2 novembre 1988, pages 87-89, IEEE, New York, US; J. WERNER et al.: "Waveguide losses of a partially disordered quantum well laser structure" * le document en entier *<br>--- -/- | 1 | |

Le présent rapport a été établi pour toutes les revendications

| Lieu de la recherche | Date d'achèvement de la recherche | Examinateur |
|---|---|---|
| BERLIN | 20-07-1992 | MUNNIX S J G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

Office européen des brevets

# RAPPORT DE RECHERCHE EUROPEENNE

Numero de la demande

EP 92 40 0960

| DOCUMENTS CONSIDERES COMME PERTINENTS | | | |
|---|---|---|---|
| Catégorie | Citation du document avec indication, en cas de besoin, des parties pertinentes | Revendication concernée | CLASSEMENT DE LA DEMANDE (Int. Cl.5) |
| A | PROC. 15TH INT. SYMP. ON GALLIUM ARSENIDE AND RELAT. COMP., ATLANTA, GA, US 11 septembre 1988, pages 83-88, Institute of Physics, Bristol, US; M. IKEDA et al.: "MOCVD growth of AlGaInP on a (III)B GaAs substrate and its application to visible lasers" * figure 4 * | 1 | |
| A | IEEE LASERS AND ELECTRO-OPTICS SOCIETY ANNUAL MEETING, SANTA CLARA, CA, US 2 novembre 1988, pages 29,30, IEEE, New York, US; R.L. THORNTON et al.: "Unified planar process for fabricating heterojunction bipolar transistors and buried heterostructure lasers utilising impurity induced disordering" * le document en entier * | 12 | |
| | | | DOMAINES TECHNIQUES RECHERCHES (Int. Cl.5) |

Le présent rapport a été établi pour toutes les revendications

| Lieu de la recherche | Date d'achèvement de la recherche | Examinateur |
|---|---|---|
| BERLIN | 20-07-1992 | MUNNIX S J G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)